# EUROPEAN PATENT SPECIFICATION

(11) **EP 2 856 185 B1**
(45) Date of publication and mention of the grant of the patent: **27.09.2017**
(21) Application number: 13727462.7
(22) Date of filing: 20.05.2013
(51) Int. Cl.: G01R 31/02, G01R 31/28, G01R 31/312, G06F 3/044, G01R 27/14, G06F 3/041

(54) **ELECTRODE TESTING APPARATUS**
ELEKTRODENTESTVORRICHTUNG
APPAREIL DE TEST D'ÉLECTRODE

(30) Priority: 30.05.2012 US 201213483746
(43) Date of publication of application: 08.04.2015
(73) Proprietor: 3M Innovative Properties Company, St. Paul, MN 55133-3427 (US)
(72) Inventor: BRITTAIN, Kenneth G., Saint Paul, Minnesota 55133-3427 (US); HERBERT, Sammuel D., Saint Paul, Minnesota 55133-3427 (US); DIAMOND, Neil F., Saint Paul, Minnesota 55133-3427 (US)
(74) Representative: Herzog, Fiesser & Partner Patentanwälte PartG mbB
(86) International application number: PCT/US2013/041760
(87) International publication number: WO 2013/181003

(56) References cited:
- US-A- 4 370 616
- US-A1- 2011 163 992

## Description

### FIELD OF THE INVENTION

This invention relates generally to devices used for testing, for example in a manufacturing setting, touch panels, particularly matrix-type transparent mutual capacitive touch panels.

### BACKGROUND

Touch sensitive devices allow a user to conveniently interface with electronic systems and displays by reducing or eliminating the need for mechanical buttons, keypads, keyboards, and pointing devices. For example, a user can carry out a complicated sequence of instructions by simply touching an on-display touch screen at a location identified by an icon. Touch sensitive devices have two principle components: a touch panel, which is usually that part with which a user makes contact; and a controller, coupled to the touch panel, to decipher touches occurring thereon. Touch panels are typically comprised of an upper and lower arrays of transparent electrodes, arranged orthogonally to one another and separated by a dielectric. Touch panels may fail when resistivity on any one of the electrodes exceeds what the controller can accommodate.

US 4,370,616 A discloses a low impedance electrostatic detector. US 2011/0163992 A1 discloses a high speed noise tolerant multi-touch touch device and a controller therefor.

### BRIEF SUMMARY

A circuit and device for inferring the resistance of an electrode by introducing a signal, via capacitive coupling, to a stimulation point of the electrode, and measuring a resultant signals at a measurement point on the electrode. A measurement circuit features a virtual ground amplifier circuit configured to produce a signal that has certain characteristics that are a linear function of the resistance of the electrode between the stimulation and measurement points. Electronics measure the characteristics, typically amplitude, and can infer therefrom the resistance of the electrode.

### BRIEF DESCRIPTION OF DRAWINGS

FIG. 1 is a schematic view of a touch device;
FIG. 2 is a schematic side view of a portion of a touch panel used in a touch device;
FIG. 3 is a circuit diagram of an electrode testing apparatus; and
FIG. 4 is a graph of a stimulating signal applied to an electrode, and corresponding signals at various points in the circuit of FIG. 3.

In the figures, like reference numerals designate like elements.

### DETAILED DESCRIPTION OF ILLUSTRATIVE EMBODIMENTS

Construction particulars of modern projected capacitive transparent touch screens, the type commonly used to overlay an electronic display and provide a user with touch-based interactivity, make evaluating and testing the touch panel components difficult after certain stages of the panel construction manufacturing process. For example, a projected capacitive touch screen stack may typically comprise upper and lower electrode arrays, orthogonally oriented to one another, and separated by a dielectric. After the stack is constructed, usually by a lamination process involving separate layers of materials, only one end of the electrodes of the upper or lower arrays may be available for physical electric connections. This limits the types of testing that may be applied to the touch screen stack, which is unfortunate because the types of materials used in such electrodes can fail in myriad ways, and some of these failure modes may not be detectable until the panel is coupled with a controller (which is typically late in the manufacturing process).

Traditional methods of touch panel testing would then involve coupling the individual arrays of the panel to a testing system and testing for certain basic failure scenarios existing between a stimulated electrode and a receive electrode (signals applied to the stimulated electrode capacitively coupling to the receive electrode at the point they cross over one another - also referred to as a node). Such existing testing approaches yield quite basic data, for example whether an electrode has a discontinuity ("open") or is erroneously connected with another component of the panel ("short"). If an open condition is detected, further testing might give an indication of where the discontinuity exists, which may be used to improve manufacturing processes. If a short condition is detected, the applied signal will be significantly attenuated either on the other end of the stimulated electrode (if there is access to such) or on the receive electrode, or the applied signal may appear on multiple receive electrodes (if the short condition exists between the drive electrode and one of the receive electrodes of the other array). A short on the stimulated electrode may be somewhat more difficult to detect, but the simulated electrode may be treated as a receive electrode by essentially flipping the touch panel and stimulating electrodes previously associated with receives, and receiving on the electrodes previously associated with being stimulated.

Basic testing such as for opens and shorts will not reveal certain conditions associated with electrodes in a panel (or the tail to which the electrodes are bonded which then couples the electronics to the controller) that could be either indicative of likely subsequent failure or indicative of manufacturing defects. Such conditions may include unusual resistivity values. For example, in panels comprised of fine micro-wire patterns (see, for example, US Pat. No. 8,179,381, "Touch Screen Sensor"), individual electrodes may comprise very fine features. The failure mode of these features may be such that they pass a basic open / short testing regime, but anomalies may be present when the resistivity values of particular electrodes, or portions of electrodes, are queried. This leads back to the earlier mentioned issue, however, which involves the difficulty of measuring resistivity of an electrode when one only has physical connection access to one side of that electrode.

This disclosure presents a novel apparatus and method to infer the resistivity of an electrode with a physical electrical connection to one point of the electrode, and a capacitively coupled connection to another point. With such apparatus and method, it is possible to infer relative or quantified resistivity values of electrodes a capacitive touch screen. These values could be used to identify panels having electrodes in a pre-failure state that would pass traditional open/short type quality control testing. Additionally, these values could be used to identify manufacturing defects that should be addressed. While this apparatus and method are presented in the context of testing a panel component of a touch-sensitive device (the device comprising both the panel along with controller electrics), there are other non-touch applications that will present themselves to those skilled in the art, where resistivity values may be needed but where it is not practical or feasible to physically electrically couple to both ends of the electrode under test. Such applications might include measuring and quantifying cross-talk field coupling; testing other types of capacitive-based sensors, such as membrane type capacitive switches or touch sensors; or testing electrodes in any application where there is only physical electrical coupling to one part of the electrode to be tested, and there is only capacitive coupling access to another point. Physical electrical coupling means electrical coupling by physical connection, rather than by capacitive coupling.

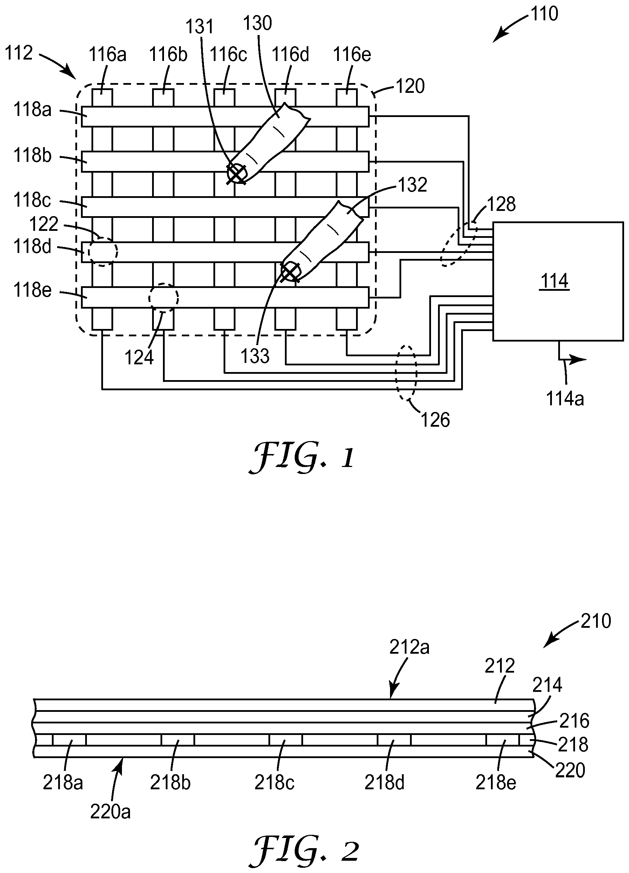

In FIG. 1, an exemplary touch device **110** is shown. The device **110** includes a touch panel **112** connected to electronic circuitry, which for simplicity is grouped together into a single schematic box labeled **114** and referred to collectively as a controller.
The touch panel **112** is shown as having a 5x5 matrix comprised of a lower array of column electrodes **116a-e** and an upper array of row electrodes **118a-e**, but other numbers of electrodes and other matrix sizes can also be used. The panel **112** is typically substantially transparent so that the user is able to view an object, such as the pixilated display of a computer, hand-held device, mobile phone, or other peripheral device, through the panel **112**. The boundary **120** represents the viewing area of the panel **112** and also preferably the viewing area of such a display, if used. The electrodes **116a-e**, **118a-e** are spatially distributed, from a plan view perspective, over the viewing area **120**. For ease of illustration the electrodes are shown to be wide and obtrusive, but in practice they may be relatively narrow and inconspicuous to the user. Further, they may be designed to have variable widths, e.g., an increased width in the form of a diamond- or other-shaped pad in the vicinity of the nodes of the matrix in order to increase the inter-electrode fringe field and thereby increase the effect of a touch on the electrode-to-electrode capacitive coupling. In exemplary embodiments the electrodes may be composed of indium tin oxide (ITO), a network of fine micro-conductor wires, or other suitable electrically conductive materials. From a depth perspective, the column electrodes may lie in a different plane than the row electrodes (from the perspective of FIG. 1, the column electrodes **116a-e** lie underneath the row electrodes **118a-e**) such that no significant ohmic contact is made between column and row electrodes, and so that the only significant electrical coupling between a given column electrode and a given row electrode is capacitive coupling. In other embodiments, the row electrode and discreet column electrode components may be disposed on the same substrate, in the same layer, then bridging jumper electrodes configured to connect the discreet column electrode components (spaced apart from the column electrode by a dielectric) to thus form x- and y- electrodes using a substantially single layer construction. The matrix of electrodes typically lies beneath a cover glass, plastic film, or the like, so that the electrodes are protected from direct physical contact with a user's finger or other touch-related implement. An exposed surface of such a cover glass, film, or the like may be referred to as a touch surface. Additionally, in display-type applications, a back shield may be placed between the display and the touch panel **112**. Such a back shield typically consists of a conductive ITO coating on a glass or film, and can be grounded or driven with a waveform that reduces signal coupling into touch panel **112** from external electrical interference sources. Other approaches to back shielding are known in the art. In general, a back shield reduces noise sensed by touch panel **112**, which in some embodiments may provide improved touch sensitivity (e.g., ability to sense a lighter touch) and faster response time. Back shields are sometimes used in conjunction with other noise reduction approaches, including spacing apart touch panel **112** and a display, as noise strength from LCD displays, for example, rapidly decreases over distance. In addition to these techniques, other approaches to dealing with noise problems are discussed in reference to various embodiments, below.

The capacitive coupling between a given row and column electrode is primarily a function of the geometry of the electrodes in the region where the electrodes are closest together. Such regions correspond to the "nodes" of the electrode matrix, some of which are labeled in FIG. 1. For example, capacitive coupling between column electrode **116a** and row electrode **118d** occurs primarily at node **122**, and capacitive coupling between column electrode **116b** and row electrode **118e** occurs primarily at node **124**. The 5x5 matrix of FIG. 1 has 25 such nodes, any one of which can be addressed by controller **114** via appropriate selection of one of the control lines **126**, which individually couple the respective column electrodes **116a-e** to the controller, and appropriate selection of one of the control lines **128**, which individually couple the respective row electrodes **118a-e** to the controller.

When a finger **130** of a user or other touch implement comes into contact or near-contact with the touch surface of the device **110**, as shown at touch location **131**, the finger capacitively couples to the electrode matrix. The finger capacitively couples to the matrix, and draws charge away from the matrix, particularly from those electrodes lying closest to the touch location, and in doing so it changes the coupling capacitance between the electrodes corresponding to the nearest node(s). For example, the touch at touch location **131** lies nearest the node corresponding to electrodes **116c/118b**. As described further below, this change in coupling capacitance can be detected by controller **114** and interpreted as a touch at or near the **116a**/**118b** node. Preferably, the controller is configured to rapidly detect the change in capacitance, if any, of all of the nodes of the matrix, and is capable of analyzing the magnitudes of capacitance changes for neighboring nodes so as to accurately determine a touch location lying between nodes by interpolation. Furthermore, the controller **114** advantageously is designed to detect multiple distinct touches applied to different portions of the touch device at the same time, or at overlapping times. Thus, for example, if another finger **132** touches the touch surface of the device **110** at touch location **133** simultaneously with the touch of finger **130**, or if the respective touches at least temporally overlap, the controller is preferably capable of detecting the positions **131**, **133** of both such touches and providing such locations on a touch output **114a**. The controller **114** preferably employs a variety of circuit modules and components that enable it to rapidly determine the coupling capacitance at some or all of the nodes of the electrode matrix, and there from determine the occurrence of contacts made to the surface of the touch panel.

Turning now to FIG. 2, we see there a schematic side view of a portion of a touch panel **210** for use in a touch device. The panel **210** includes a front layer **212**, first electrode layer **214** comprising a first set of electrodes, insulating layer **216**, second electrode layer **218** comprising a second set of electrodes **218a-e** preferably orthogonal to the first set of electrodes, and a rear layer **220**. The exposed surface **212a** of layer **212**, or the exposed surface **220a** of layer **220**, may be or comprise the touch surface of the touch panel **210**.

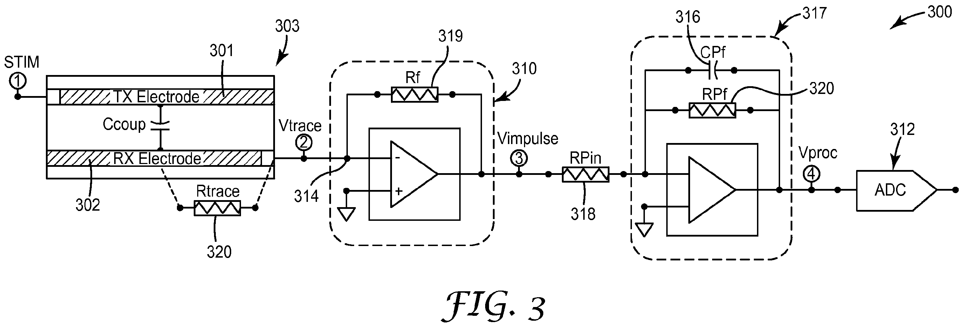

FIG. 3 is a schematic of electrode testing system **300**. A representative node of touch panel **303** is shown, the portion comprising a driven electrode **301** and a receive electrode **302**, with capacitive coupling Ccoup between them. Driven electrode **301** is physically electrically coupled to a signal generator (not shown in FIG. 3) which provides a stimulating signal. The stimulating signal capacitively couples to receive electrode **302**, to provide Vtrace signal to amplifier circuit **310**. Amplifier circuitr **310** is commercially available from Texas Instruments (product number OPA4134: ultra-low distortion, low noise.

Typically, a further resistor, sometimes referred to as an input resistor, would precede virtual ground node **314** (i.e., a further resistor would be positioned immediately to the left of virtual ground node **314**). The function of such input resistor is, among other things, to isolate amplifier **310** from the electrode. It has been discovered, however, that by removing this input resistor, or making it significantly small, the resistance of the measured trace Rtrace **320** can be fed directly into the virtual ground node **311**. Significantly small, as such term is used herein, means small enough that the resultant signal from the virtual ground amplifier has characteristics that are a function of the resistance of the electrode. The resultant signal is a combination of the coupled drive, or stimulating, signal and the electrode resistance. Ideally amplifier circuit **310** normalizes to ground whatever signal is provided to amplifier circuit **310**. In real world conditions, however, the virtual grounding circuit is not ideal, and there is a small but important impulse signal Vimpluse produced by amplifier circuit **310**. This signal is the result of amplifier circuit **310** attempting to ground out the signal provided to it; or, in other words, amplifier **310** is brings the signal Vtrace to a ground potential, which causes what little energy that was coupled into Rtrace to be forced to zero. This transforms the original coupled energy into an impulse event. Since the resistivity of the trace (Rtradce **320**) is coupled, along with the feedback resistance Rf **319,** to the virtual ground node, the peak of the resulting waveform Vimpulse is a linear function of the resistance of the trace. Thus, the peak of the resulting impulse will vary as a linear function of the resistance of electrode. It would be expected that shorting the signal Vtrace to ground would result in a signal with such low energy content that shorting it to ground would not leave any measurable or useful signal content. However, it has been discovered that there is enough energy in the resulting impulse signal Vimpulse that it is possible to extract a stable signal with significant content. Note that Rtrace 320 has dashed lines pointing to the capacitive coupling stimulation point of the Rx electrode 302 (left dashed line) and the right end of the Rx electrode **302**, where electrode testing system 300 would be physically electrically coupled to RX electrode **302**, either directly or via a tail or other circuitry. It is the resistivity of the electrode between these two points that is of being quantified by the electrode testing system. Physically electrically coupled, as such term is used herein, refers to physical (as opposed to mere capacitive) coupling of components. For example, conductors physically couple components of a circuit to one another.

Due to the low signal level of the impulse signal Vimpulse, a secondary gain stage amplification is applied to the signal. Amplifier circuit **320** is thus used to further condition and amplify the impulse signal Vimpulse resulting from amplifier circuit **310**, to produce signal Vproc, which is then digitized by analog-to-digital converter (ADC) **312**. Amplifier circuit **310** is a low pass filter from where CPf is used to limit the frequency content of the generated signal, effectively filtering out high frequency noise. Different sensor types will generate different peak voltage levels Resistor **317** and resistor **318** are chosen to scale the resulting signal Vproc into the full dynamic range of ADC **312**, increasing signal to noise of the resulting signal. Once digitized by ADC **312**, the signal is further processed, one manner of such further processing including peak detection of the resulting signal. Relative resistance measurements of the trace may be inferred by correlating it with the relative size of the detected peak. If actual resistance measurements (as opposed to relative) are desired, a calibration formula or lookup table may be used that associates a measured signal peak with the resistance of a given trace / touch panel design. Generally, it is assumed there is uniform spacing between capacitively coupled electrodes of the upper and lower electrode arrays.

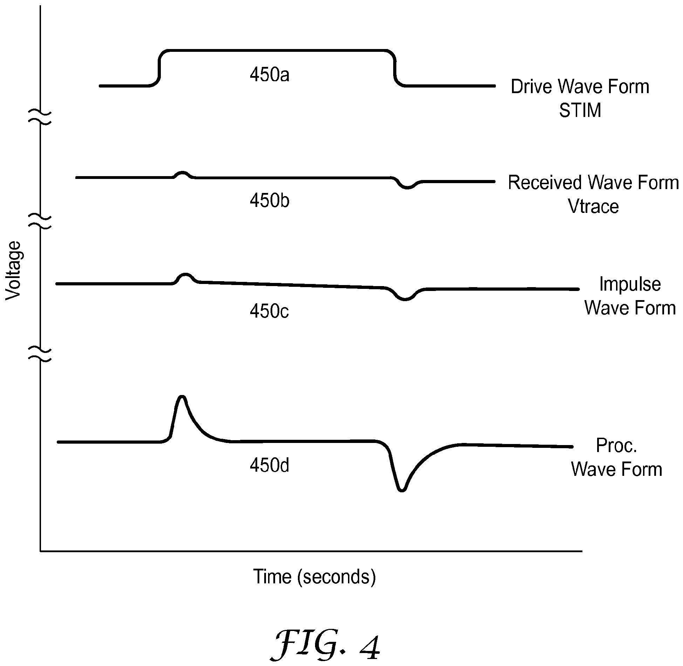

FIG. 4 shows representative waveforms occurring at various positions along testing system **300** for the evaluation of an electrode on touch panel **303**. Particularly, drive waveform **450a** (STIM) is shown at position 1 in FIG. 3. The drive waveform is a square wave having peak values consistent with transistor-transistor logic (TTL) level outputs, usually in range of 3.3-5 volts. The received waveform **450b** (VTRACE), occurring at position 2 in FIG. 3, is a weak signal, on the order of 2 millivolts. Noise levels occurring at position 2 will routinely exceed this signal level, but such noise has a higher frequency content and is filtered out by the low pass filter. Impulse waveform **450c**, occurring at measurement position 3 in FIG. 3, is on the order of about 200 millivolts. After the amplification / filtering stage (amplifier **320**), the resulting PROC waveform **450d** is shown as occurring at measurement point 4. It is the PROC waveform that is digitized by ADC **312**, then peak detected. The peak detected waveform may then be used as-is for relative measurements, or converted into ohms by means of an equation and/or a lookup table.
Testing system **300** may be incorporated into a touch panel testing apparatus. Such an apparatus may be used to test electrodes in mutual-capacitive based touch panels for abnormal resistivity. Such testing is typically only possible with physical electrical access to both ends of an electrode, and modern touch panels may provide such physical electrical access to only one end of a touch panel electrode. That is, for one of the two arrays of electrodes that comprise most modern mutual capacitive touch panels (typically upper and lower arrays separated by a dielectric), a tail is typically electrically coupled to both arrays, and often just one end of both arrays - i.e., there is only the possibility of physical electrical coupling to the tail side of the electrode; the other side is buried. Some touch panels do, however, have tails on both ends of electrodes of either the upper or lower arrays (or sometimes both the upper and the lower). In such panels that have physical electrical access to both sides of the electrode, the above described measurements system may still be advantageously used to measure resistivity. This is because the use of a standard resistance measurement technique, by connecting to both sides of an electrode, can only provide a total resistance measurement of the electrode under test. The inferred measurement produced through capacitive coupled events, as described herein, allow measurement of resistance at any point in the electrode, but particularly at node points. Such ability to measure at any point along the electrode can be important, because electrodes may exhibit correct total resistance but show poor resistance distribution, which will lead to poorly functioning touch panels. The scope of the invention is defined by the appended set of claims.

## Claims

1. An apparatus (300) for inferring a resistivity of an electrode (302) between a stimulation point (Ccoup) located between two ends of the electrode (302) and a measurement point at one of the two ends of the electrode (302), wherein a drive signal (STIM) is introduced into the electrode (302) at the stimulation point (Ccoup) by capacitive coupling, and the measurement point is physically electrically coupled to a measurement circuitry comprising an amplifier circuit (310) configured to produce a resultant signal (Vimpulse) that is a function of the resistivity of the electrode (302) between the stimulation point (Ccoup) and the measurement point.

2. The apparatus (300) of claim 1, wherein the amplifier circuit (310) comprises a virtual ground amplifier having a virtual ground node (314), and wherein the measured trace (320) is directly physically electrically coupled to the virtual ground node (314).

3. The apparatus (300) of claim 2, wherein directly physically electrically coupled comprises the absence of a resistor between the measurement point of the electrode (302) and the virtual ground node (314).

4. The apparatus (300) of claim 2, wherein directly physically electrically coupled comprises a significantly small resistor is between the measurement point of the electrode (302) and the virtual ground node (314), wherein the significantly small resistor is sufficiently small so that the resultant signal (Vimpulse) is a function of the resistivity of the electrode (302) between the stimulation point (Ccoup) and the measurement point.

5. The apparatus (300) of claim 2, wherein the resultant signal's amplitude is a function of the resistivity of the electrode (302).

6. The apparatus (300) of claim 5, wherein the resultant signal's amplitude is a linear function of the resistivity of the electrode (302).

7. The apparatus (300) of claim 2, further comprising a peak detector for detecting the peak voltage of the resultant signal (Vimpulse).

8. The apparatus (300) of claim 1, wherein the amplifier circuit comprising:
a virtual ground amplifier having a virtual ground node (314), and wherein the measured trace (320) is directly physically electrically coupled to the virtual ground node (314); and
a peak detector for detecting the peak voltage of the resultant signal (Vimpulse).

9. A touch panel testing device that determines a resistivity for at least some of the electrodes (301) in a mutual capacitive touch panel (112) having a first and second array (116a-e, 118a-e) of electrodes separated by a dielectric and configured such that electrical signals applied to an electrode of either array capacitively couple to the electrodes of the other array, comprising:
a drive signal generator electrically coupled to an electrode of the first array (116a-e);
a measurement circuit physically electrically coupled to at least one electrode of the second array (118a-e) at a measurement point, the measurement point being one of two ends of the at least one electrode, the at least one electrode of the second array (118a-e) crossing over the electrode of the first array (116a-e) at a stimulation point (Ccoup), the stimulation point (Ccoup) located between the two ends of the at least one electrode, the measurement circuit comprising:
a virtual ground amplifier having a virtual ground node (314), wherein the virtual ground node (314) is physically electrically coupled to the at least one electrode at the measurement point, the virtual ground amplifier producing a resultant signal (Vimpulse) that is a function of the resistivitiy of the at least one electrode of the second array (118a-e) between the stimulation point (Ccoup) and the measurement point.

10. The touch panel testing device of claim 9, wherein physically electrically coupled comprises the absence of a resistor between the at least one electrode and the virtual ground node (314).

11. The touch panel testing device of claim 9, wherein directly physically electrically coupled comprises analog circuitry consisting only of one or more significantly small resistors between the virtual ground node (314) and the at least one electrode.

## Patentansprüche

1. Vorrichtung (300) zum Ableiten eines spezifischen Widerstands einer Elektrode (302) zwischen einem zwischen zwei Enden der Elektrode (302) angeordneten Stimulationspunkt (Ccoup) und einem Messpunkt an einem der beiden Enden der Elektrode (302), wobei ein Stellsignal (STIM) in die Elektrode (302) am Stimulationspunkt (Ccoup) durch kapazitive Kopplung eingeführt wird und der Messpunkt physikalisch elektrisch mit einer Messschaltung verbunden ist, die eine Verstärkerschaltung (310) aufweist, die so konfiguriert ist, dass sie ein resultierendes Signal erzeugt (Vimpulse), das eine Funktion des spezifischen Widerstands der Elektrode (302) zwischen dem Stimulationspunkt (Ccoup) und dem Messpunkt ist.

2. Vorrichtung (300) nach Anspruch 1, wobei die Verstärkerschaltung (310) einen virtuellen Masseverstärker mit einem virtuellen Masseknoten (314) aufweist und wobei die gemessene Spur (320) direkt physikalisch elektrisch mit dem virtuellen Masseknoten (314) gekoppelt ist.

3. Vorrichtung (300) nach Anspruch 2, wobei "direkt physikalisch elektrisch gekoppelt" das Fehlen eines Widerstands zwischen dem Messpunkt der Elektrode (302) und dem virtuellen Masseknoten (314) umfasst.

4. Vorrichtung (300) nach Anspruch 2, bei der "direkt physikalisch elektrisch gekoppelt" einen im Wesentlichen kleinen Widerstand zwischen dem Messpunkt der Elektrode (302) und dem virtuellen Masseknoten (314) umfasst, wobei der im Wesentlichen kleine Widerstand ausreichend klein ist, sodass das resultierende Signal (Vimpulse) eine Funktion des spezifischen Widerstands der Elektrode (302) zwischen dem Stimulationspunkt (Ccoup) und dem Messpunkt ist.

5. Vorrichtung (300) nach Anspruch 2, wobei die resultierende Signalamplitude eine Funktion des spezifischen Widerstands der Elektrode (302) ist.

6. Vorrichtung (300) nach Anspruch 5, wobei die resultierende Signalamplitude eine lineare Funktion des spezifischen Widerstands der Elektrode (302) ist.

7. Vorrichtung (300) nach Anspruch 2, weiter umfassend einen Peak-Detektor zum Detektieren der Spitzenspannung des resultierenden Signals (Vimpulse).

8. Vorrichtung (300) nach Anspruch 1, wobei die Verstärkerschaltung Folgendes umfasst:
einen virtuellen Masseverstärker mit einem virtuellen Masseknoten (314), und wobei die gemessene Spur (320) direkt physikalisch elektrisch mit dem virtuellen Masseknoten (314) gekoppelt ist; und einen Peak-Detektor zum Detektieren der Spitzenspannung des resultierenden Signals (Vimpulse).

9. Touchpanel-Prüfeinrichtung, die einen spezifischen Widerstand bestimmt für zumindest einige der Elektroden (301) in einem wechselseitigen kapazitiven Touchpanel (112) mit einem ersten und zweiten Array (116a-e, 118a-e) von Elektroden, durch ein Dielektrikum getrennt und so konfiguriert, dass elektrische Signale, mit denen eine Elektrode eines der Arrays beaufschlagt wird, kapazitiv an die Elektroden des jeweils anderen Arrays koppeln, Folgendes umfassend:
einen Stellsignalgenerator, elektrisch gekoppelt mit einer Elektrode des ersten Arrays (116a-e);
eine Messschaltung, physikalisch elektrisch gekoppelt an mindestens eine Elektrode des zweiten Arrays (118a-e) an einem Messpunkt, wobei der Messpunkt eines von zwei Enden der mindestens eine Elektrode ist, wobei die mindestens eine Elektrode des zweiten Arrays (118a-e) die Elektrode des ersten Arrays (116a-e) an einem Stimulationspunkt (Ccoup) überquert, wobei der Stimulationspunkt (Ccoup) zwischen den beiden Enden der mindestens eine Elektrode angeordnet ist, wobei die Messschaltung Folgendes umfasst:
einen virtuellen Masseverstärker mit einem virtuellen Masseknoten (314), wobei der virtuelle Masseknoten (314) am Messpunkt physikalisch elektrisch mit der mindestens einen Elektrode gekoppelt ist, wobei der virtuelle Masseverstärker ein resultierendes Signal (Vimpulse) erzeugt, das eine Funktion des spezifischen Widerstands der mindestens einen Elektrode des zweiten Arrays (118a-e) zwischen dem Stimulationspunkt (Ccoup) und dem Messpunkt ist.

10. Touchpanel-Prüfvorrichtung nach Anspruch 9, wobei "physikalisch elektrisch gekoppelt" das Fehlen eines Widerstands zwischen der mindestens einen Elektrode und dem virtuellen Masseknoten (314) umfasst.

11. Touchpanel-Prüfvorrichtung nach Anspruch 9, wobei "direkt physikalisch elektrisch gekoppelt" analoge Schaltung umfasst, die nur aus einem oder mehreren signifikant kleinen Widerständen zwischen dem virtuellen Masseknoten (314) und der mindestens einen Elektrode besteht.

## Revendications

1. Appareil (300) de déduction d'une résistivité d'une électrode (302) entre un point de stimulation (Ccoup) situé entre deux extrémités de l'électrode (302) et un point de mesure au niveau d'une des deux extrémités de l'électrode (302), dans lequel un signal d'entraînement (STIM) est introduit dans l'électrode (302) au niveau du point de stimulation (Ccoup) par un couplage capacitif et le point de mesure est physiquement électriquement couplé à un ensemble de circuits de mesure comprenant un circuit d'amplitifcateur (310) conçu pour produire un signal résultant (Vimpulse) qui est une fonction de la résistivité de l'électrode (302) entre le point de stimulation (Ccoup) et le point de mesure.

2. Appareil (300) selon la revendication 1, dans lequel le circuit d'amplificateur (310) comprend un amplificateur de masse virtuel ayant un noeud de masse virtuel (314) et dans lequel la trace mesurée (320) est directement physiquement électriquement couplée au noeud de masse virtuel (314).

3. Appareil (300) selon la revendication 2, dans lequel directement physiquement électriquement couplé comprend l'absence d'une résistance entre le point de mesure de l'électrode (302) et le noeud de masse virtuel (314).

4. Appareil (300) selon la revendication 2, dans lequel directement physiquement électriquement couplé comprend une résistance significativement faible entre le point de mesure de l'électrode (302) et le noeud de masse virtuel (314), dans lequel la résistance significativement faible est suffisamment faible pour que le signal résultant (Vimpulse) soit fonction de la résistivité de l'électrode (302) entre le point de stimulation (Ccoup) et le point de mesure.

5. Appareil (300) selon la revendication 2, dans lequel l'amplitude du signal résultant est une fonction de la résistivité de l'électrode (302).

6. Appareil (300) selon la revendication 5, dans lequel l'amplitude du signal résultant est une fonction linéaire de la résistivité de l'électrode (302).

7. Appareil (300) selon la revendication 2, comprenant en outre un détecteur de crête pour détecter la tension de crête du signal résultant (Vimpulse).

8. Appareil (300) selon la revendication 1, dans lequel le circuit d'amplificateur comprend :
un amplificateur de masse virtuel ayant un noeud de masse virtuel (314) et dans lequel la trace mesurée (320) est directement physiquement électriquement couplée au noeud de masse virtuel (314) ; et un détecteur de crête pour détecter la tension de crête du signal résultant (Vimpulse).

9. Dispositif de test de panneau tactile qui détermine une résistivité pour au moins certaines des électrodes (301) dans un panneau tactile capacitif mutuel (112) ayant un premier et un second réseau (116a-e, 118a-e) d'électrodes séparés par un diélectrique et conçus de sorte que des signaux électriques appliqués à une électrode d'un réseau ou l'autre se couplent de manière capacitive aux électrodes de l'autre réseau, comprenant :
un générateur de signal d'entraînement électriquement couplé à une électrode du premier réseau (116a-e) ;
un circuit de mesure physiquement électriquement couplé à au moins une électrode du second réseau (118a-e) au niveau d'un point de mesure, le point de mesure étant une des deux extrémités de l'au moins une électrode, l'au moins une électrode du second réseau (118a-e) traversant au-dessus de l'électrode du premier réseau (116a-e) au niveau d'un point de stimulation (Ccoup), le point de stimulation (Ccoup) étant situé entre les deux extrémités de l'au moins une électrode, le circuit de mesure comprenant :
un amplificateur de masse virtuel ayant un noeud de masse virtuel (314), dans lequel le noeud de masse virtuel (314) est physiquement électriquement couplé à l'au moins une électrode au niveau du point de mesure, l'amplificateur de masse virtuel produisant un signal résultant (Vimpulse) qui est une fonction de la résistivité de l'au moins une électrode du second réseau (118a-e) entre le point de stimulation (Ccoup) et le point de mesure.

10. Dispositif de test de panneau tactile selon la revendication 9, dans lequel physiquement électriquement couplé comprend l'absence d'une résistance entre l'au moins une électrode et le noeud de masse virtuel (314).

11. Dispositif de test de panneau tactile selon la revendication 9, dans lequel directement physiquement électriquement couplé comprend un ensemble de circuits analogiques constitué uniquement d'une ou de plusieurs résistances significativement faibles entre le noeud de masse virtuel (314) et l'au moins une électrode.
